# EUROPÄISCHE PATENTSCHRIFT

(11) **EP 1 673 533 B1**
(45) Veröffentlichungstag und Bekanntmachung des Hinweises auf die Patenterteilung: **23.12.2015**
(21) Anmeldenummer: 04791203.5
(22) Anmeldetag: 12.10.2004
(51) Int. Cl.: F02M 63/00, H01L 41/053, H01L 41/083

(54) **PIEZOAKTOR UND ZUGEHÖRIGES HERSTELLUNGSVERFAHREN**
PIEZOELECTRIC ACTUATOR AND ASSOCIATED PRODUCTION METHOD
ACTIONNEUR PIEZOELECTRIQUE ET PROCEDE DE PRODUCTION ASSOCIE

(30) Priorität: 14.10.2003 DE 10347771
(43) Veröffentlichungstag der Anmeldung: 28.06.2006
(73) Patentinhaber: Continental Automotive GmbH, 30165 Hannover (DE)
(72) Erfinder: DÖLLGAST, Bernd, 91054 Erlangen (DE); SCHUH, Carsten, 85598 Baldham (DE); ZUMSTRULL, Claus, 93128 Regenstauf (DE)
(86) Internationale Anmeldenummer: PCT/EP2004/052511
(87) Internationale Veröffentlichungsnummer: WO 2005/035971

(56) Entgegenhaltungen:
- EP-A- 1 079 097
- WO-A-03/005490
- WO-A-2004/004021
- DE-A- 19 715 487
- DE-A- 19 910 111

## Beschreibung

Die Erfindung betrifft einen Piezoaktor, insbesondere für einen Piezoaktor zum Antrieb eines Injektors für eine Einspritzanlage einer Brennkraftmaschine gemäß dem Oberbegriff des Anspruchs 1 sowie ein zugehöriges Herstellungsverfahren gemäß Anspruch 16.

In modernen Einspritzanlagen für Brennkraftmaschinen werden zum Antrieb der Injektoren zunehmend Piezoaktoren eingesetzt, die im Wesentlichen aus einem Stapel zahlreicher übereinander angeordneter schichtförmiger Piezoelemente bestehen. Zwischen den einzelnen schichtförmigen Piezoelementen des Stapels befinden sich hierbei Elektrodenschichten, die eine elektrische Kontaktierung der unmittelbar benachbarten Piezoelemente ermöglichen. An zwei gegenüberliegenden Seitenflächen des Stapels sind ferner Metallisierungen aufgebracht, die sich über die gesamte Länge des Stapels erstrecken, wobei die Elektrodenschichten abwechselnd mit einer der beiden Metallisierungen elektrisch verbunden sind. Die eigentliche elektrische Kontaktierung des Piezoaktors erfolgt jedoch über zwei elektrisch leitfähige Anschlussstifte zwischen denen der Piezostapel angeordnet ist, wobei die beiden Anschlussstifte getrennt voneinander mit jeweils einer der beiden Metallisierungen des Piezostapels verbunden sind.

Zur Herstellung der elektrischen Verbindung zwischen den Anschlussstiften und den Metallisierungen des Piezostapels wird der Piezostapel zusammen mit den Anschlussstiften herkömmlicherweise in eine Mehrfachaufnahme eingelegt, in der die Anschlussstifte in einer vorgegebenen Position relativ zu dem Piezostapel fixiert werden, woraufhin dann ein elektrisch leitfähiger Draht in einer Vielzahl von Windungen um den Piezostapel und die Anschlussstifte gewickelt wird. Nach dieser Bewicklung des Piezostapels und der Anschlussstifte werden die einzelnen Windungen des Drahtes dann mit der Metallisierung und den Anschlussstiften verlötet, wodurch eine elektrische Verbindung zwischen den Metallisierungen und den zugehörigen Anschlussstiften hergestellt wird. Die verbleibenden Drahtabschnitte zwischen den gegenpoligen Anschlussstiften bzw. Metallisierungen werden dann durchtrennt und entfernt, um diese elektrisch gegeneinander zu isolieren. Anschließend wird auf den Piezostapel eine Passivierung aufgetragen und auf die Kanten des Piezostapels eine Folie als Kantenschutz aufgeklebt. Schließlich werden die aus einem Piezostapel und zwei Anschlussstiften bestehenden Einheiten dann aus der Mehrfachaufnahme herausgenommen und in geeignete Hülsen zum Vergießen eingesetzt.

Nachteilig an diesem bekannten Herstellungsverfahren für einen Piezoaktor ist zunächst die Tatsache, dass die einzelnen Piezoeinheiten zum Vergießen aus der Mehrfachaufnahme entnommen und zum Vergießen in die zugehörige Hülse eingesetzt werden müssen, was einen zusätzlichen Arbeitsschritt erfordert.

Zum anderen müssen die beiden Anschlussstifte einer Piezoeinheit während des Vergießens durch eine separate Führung exakt ausgerichtet werden, bis die Vergussmasse ausgehärtet ist und die Anschlussstifte dadurch unverrückbar fixiert werden.

Ferner ist eine elektrische Kontaktierung zwischen einem Piezostapel und Anschlussstiften über folienförmige Kontaktfahnen aus der DE 197 15 487 A1, der DE 199 10 111 A1 und der WO 03/005490 A2 bekannt. Zur Montage in einem Injektor können solche über eine Kontaktfahne mit Anschlussstiften verbundenen Piezostapel in eine Montagehülse eingesetzt werden. Aus der EP 1 079 097 A2 ist eine flexible Hülse für einen Piezostapel mit Anschlussdrähten und einem Kontaktelement bekannt.

Der Erfindung liegt also die Aufgabe zugrunde, das vorstehend beschriebene bekannte Herstellungsverfahren für einen Piezoaktor zu vereinfachen, wobei eine exakte Ausrichtung der Anschlussstifte des Piezoaktors sichergestellt sein muss.

Diese Aufgabe wird durch eine neuartige Montageaufnahme gemäß Anspruch 1 und durch ein zugehöriges Herstellungsverfahren gemäß Anspruch 16 gelöst.

Die Erfindung umfasst die allgemeine technische Lehre, die einzelnen Piezostapel mit den zugehörigen Anschlussstiften bei der Montage nicht in eine Mehrfachaufnahme zusammen mit anderen Piezostapeln und den zugehörigen Anschlussstiften einzulegen, sondern in eine Einzelaufnahme, die nur einen einzigen Piezostapel mit zwei zugehörigen Anschlussstiften aufnimmt. Dies bietet den Vorteil, dass der Piezoaktor anschließend in der Einzelaufnahme vergossen werden kann, wobei die Einzelaufnahme die beiden Anschlussstifte des Piezoaktors räumlich fixiert, so dass auf eine separate Führung für die beiden Anschlussstifte verzichtet werden kann. Die Erfindung sieht deshalb eine Montageaufnahme für einen Piezoaktor vor, die als Einzelaufnahme zur Aufnahme und Halterung nur eines einzigen Piezostapels mit zwei zugehörigen Anschlussstiften ausgestaltet ist.

Vorzugsweise weist die erfindungsgemäße Montageaufnahme eine Halterung mit einem integrierten Kantenschutz auf, um eine axial verlaufende Kante des Piezostapels bei der Bewicklung mit dem Draht zu schützen. Dieser Kantenschutz kann beispielsweise mindestens einen axial verlaufenden Steg aufweisen, der die zu schützende Kante des Piezostapels abdeckt. Da bei der Bewicklung der Piezoeinheit üblicherweise zwei gegenüberliegende Kanten des Piezostapels mechanisch beansprucht werden, deckt der Kantenschutz vorzugsweise zwei axial verlaufende, einander gegenüberliegende Kanten des Piezostapels ab. Ein derartiger Kantenschutz kann beispielsweise dadurch realisiert werden, dass die Halterung der erfindungsgemäßen Montageaufnahme käfigförmig ausgebildet ist und zwei Stirnplatten aufweist, die durch Stege miteinander verbunden sind, wobei die Stege zwischen den beiden Stirnplatten zusätzlich als Kantenschutz für den Piezostapel dienen.

Bei einem derartigen Kantenschutz für den Piezostapel ist es vorteilhaft, wenn zwischen dem Kantenschutz und dem Piezostapel ein Spalt verbleibt, der ausreichend groß ist, um beim Vergießen des Piezoaktors in der Montageaufnahme das Eindringen der Vergussmasse zu ermöglichen. Die hierzu erforderliche Spaltbreite hängt im Wesentlichen von der Viskosität und der Oberflächenspannung der verwendeten Vergussmasse ab und lässt sich durch einfache Versuche leicht ermitteln.

Bei der Bewicklung der Piezoeinheit mit einem elektrisch leitfähigen Draht zur Herstellung einer elektrischen Verbindung zwischen den Anschlussstiften und den zugehörigen Metallisierungen des Piezostapels wird die Piezoeinheit mit den Anschlussstiften üblicherweise relativ zu der Drahtzuführung gedreht, was während des Bewicklungsvorgangs zu einer Drahtspannung führt, die von der Drehgeschwindigkeit der Piezoeinheit und dem effektiven Bewicklungsradius der Piezoeinheit abhängt. Zur Erleichterung der Drahtbewicklung bilden die axial verlaufenden Kanten des Piezostapels mit den Anschlussstiften und dem Kantenschutz im Querschnitt vorzugsweise ein Polygon mit mindestens sechs Ecken. Eine derartige Ausgestaltung der erfindungsgemäßen Montageaufnahme bietet den Vorteil, dass die Drahtspannung während des Bewicklungsvorgangs nur geringfügige Schwankungen aufweist.

Hierbei ist zu erwähnen, dass das von den Kanten des Piezostapels, den Anschlussstiften und dem Kantenschutz gebildete Polygon in der Praxis keine mathematisch exakten Ecken und Kanten aufweist, so dass dieser Begriff anschaulich zu verstehen ist. So sind beispielsweise die Stege zwischen den Stirnplatten der käfigförmigen Halterung in der Praxis stark abgerundet, was jedoch einem polygonförmigen Drahtbewicklungsquerschnitt in dem erfindungsgemäßen Sinne nicht entgegensteht.

Besonders vorteilhaft ist es hierbei, wenn das durch die Kanten des Piezostapels, die Anschlussstifte und den Kantenschutz gebildete Polygon im Wesentlichen gleichseitig ist, um Schwankungen der Drahtspannung während der Bewicklung zu verringern. So sollte die längste Seitenkante des Polygons maximal 20% länger sein als die kürzeste Seitenkante des Polygons, wobei beliebige Zwischenwerte innerhalb dieses Intervalls möglich sind.

Vorzugsweise sind die beiden Anschlussstifte in der Halterung der erfindungsgemäßen Montageaufnahme formschlüssig fixiert, um die Anschlussstifte während des Vergießvorgangs exakt auszurichten. Dies bietet den Vorteil, dass während des Vergießvorgangs auf eine separate Führung zur Ausrichtung der Anschlussstifte verzichtet werden kann, wodurch die Herstellung wesentlich vereinfacht wird.

Die formschlüssige Fixierung der Anschlussstifte in der Halterung der erfindungsgemäßen Montageaufnahme kann beispielsweise dadurch erreicht werden, dass die Anschlussstifte mit dem Material (z.B. Kunststoff) der Halterung umspritzt oder umgossen sind.

Zur räumlichen Ausrichtung der beiden Anschlussstifte während des Vergießens sind diese vorzugsweise in zwei Querlagern fixiert, die jeweils eine Querbewegung der Anschlussstifte verhindern. Derartige Querlager können beispielsweise aus Bohrungen in den Stirnplatten der käfigartig geformten Halterung bestehen, durch welche die Anschlussstifte hindurchgeführt sind.

Vorzugsweise sind die beiden Anschlussstifte in der Halterung auch in jeweils einem Axiallager zumindest einseitig axial fixiert, um die Anschlussstifte während des Vergießens auch axial exakt zu positionieren.

Neben der vorstehend beschriebenen erfindungsgemäßen Montageaufnahme umfasst die Erfindung auch ein zugehöriges Herstellungsverfahren, bei dem der Piezostapel und die zugehörigen Anschlussstifte in eine als Einzelaufnahme ausgestaltete Montageaufnahme eingesetzt werden, wie vorstehend bereits erläutert wurde.

Andere vorteilhafte Weiterbildungen der Erfindung sind in den Unteransprüchen gekennzeichnet oder werden nachstehend zusammen mit der Beschreibung des bevorzugten Ausführungsbeispiels der Erfindung anhand der Zeichnungen näher erläutert. Es zeigen:
- Figur 1: eine Perspektivansicht einer erfindungsgemäßen Montageaufnahme,
- Figur 2: eine Perspektivansicht eines Piezostapels, der zur Montage eines Piezoaktors in die in Figur 1 gezeigte Montageaufnahme eingesetzt werden kann,
- Figur 3: die in Figur 1 gezeigte Montageaufnahme, in die der in Figur 2 gezeigte Piezostapel eingesetzt ist, sowie
- Figur 4: einen fertigen Piezoaktor in vergossenem Zustand.

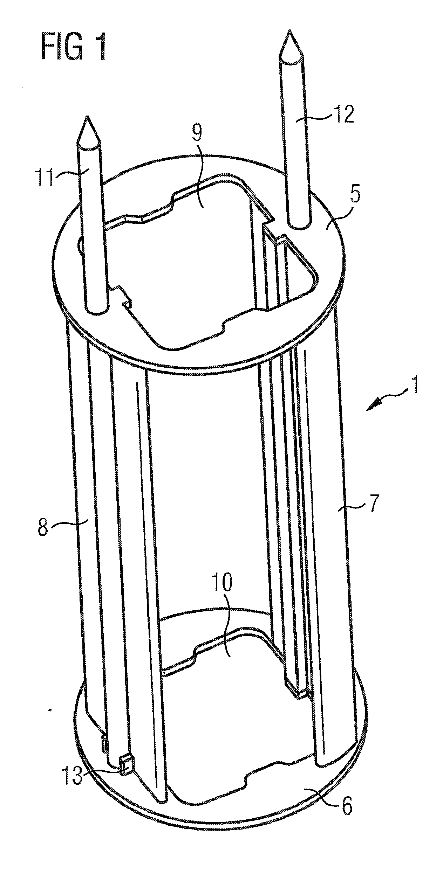

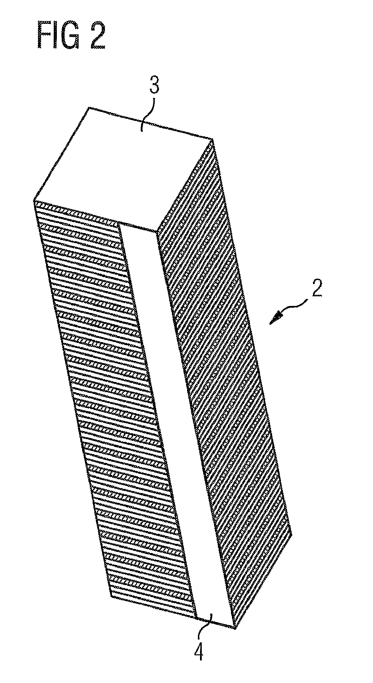

Die Perspektivansicht in Figur 1 zeigt eine Montageaufnahme 1 für einen Piezostapel 2, der detailliert in Figur 2 dargestellt ist und im Folgenden kurz beschrieben wird.

Der Piezostapel 2 besteht aus einer Vielzahl von stapelförmig übereinander angeordneten, schichtförmigen Piezoelementen 3, wobei zwischen den einzelnen Piezoelementen 3 jeweils eine Elektrodenschicht angeordnet ist.

Zur elektrischen Kontaktierung des Piezostapels 2 ist auf zwei gegenüberliegenden Seitenflächen des Piezostapels jeweils eine Metallisierung 4 aufgebracht, die sich über die gesamte Länge des Piezostapels 2 erstreckt, wobei die einzelnen Elektrodenschichten des Piezostapels 2 abwechselnd mit der Metallisierung 4 und mit der gegenüberliegenden und in der Zeichnung nicht sichtbaren Metallisierung verbunden sind.

Bei der Montage eines Piezoaktors wird der vormontierte Piezostapel 2 in die Montageaufnahme 1 eingeführt. Die Montageaufnahme 1 ist hierzu käfigförmig ausgebildet und weist zwei Stirnplatten 5, 6 auf, die durch längs verlaufende Stege 7, 8 miteinander verbunden sind, wobei in den beiden Stirnplatten 5, 6 jeweils eine Aussparung 9, 10 angeordnet ist, durch die der Piezostapel in die Montageaufnahme 1 eingeführt werden kann. Im montierten Zustand ragt der Piezostapel 2 dann geringfügig in axialer Richtung aus der Montageaufnahme 1 durch die Aussparungen 9, 10 heraus, wodurch die Aussparungen 9, 10 den Piezostapel 2 fixieren.

Weiterhin sind in der oberen Stirnplatte 5 seitlich neben der Aussparung 9 Bohrungen zur Aufnahme von zwei Anschlussstiften 11, 12 vorgesehen, während die untere Stirnplatte 6 jeweils ein Klemmlager 13 aufweist, das an die Stirnplatte 6 einstückig angeformt ist und das untere Ende des Anschlussstifts 11 bzw. 12 in Querrichtung führt. Hierbei liegt das untere Ende des Anschlussstifts 11 bzw. 12 auf der Oberseite der Stirnplatte 6 auf und wird dadurch einseitig axial fixiert, so dass die beiden Anschlussstifte 11, 12 die gleiche Axiallage aufweisen.

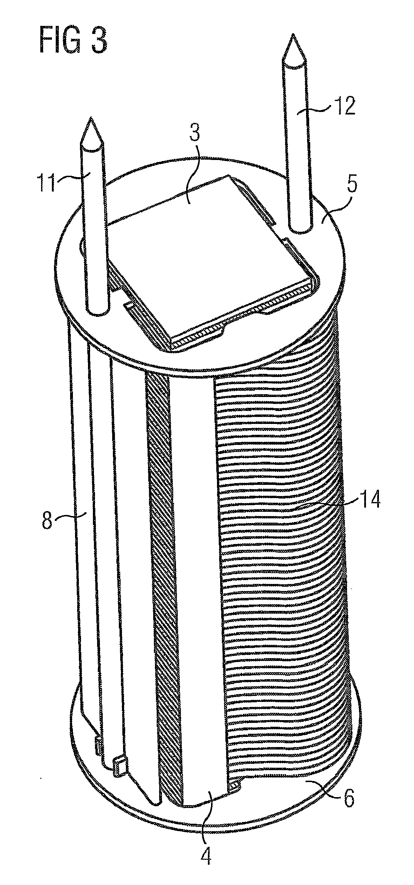

Nach dem Einsetzen des Piezostapels 2 in die Montageaufnahme 1 wird die aus der Montageeinheit 1 und dem Piezostapel 2 bestehende Einheit dann mit einem elektrisch leitfähigen Draht 14 bewickelt, wie aus Figur 3 ersichtlich ist.

Anschließend wird der Draht 14 dann mit den beiden Anschlussstiften 11, 12, der Metallisierung 4, sowie der gegenüberliegenden und nicht sichtbaren Metallisierung des Piezostapels 2 verlötet, um eine elektrische Verbindung herzustellen.

Die Drahtabschnitte zwischen der Metallisierung 4 und dem Anschlussstift 11 und die Drahtabschnitte zwischen dem Anschlussstift 12 und der gegenüberliegenden Metallisierung werden dann durchtrennt und entfernt, um die beiden Metallisierungen 4 des Piezostapels 2 elektrisch gegeneinander zu isolieren.

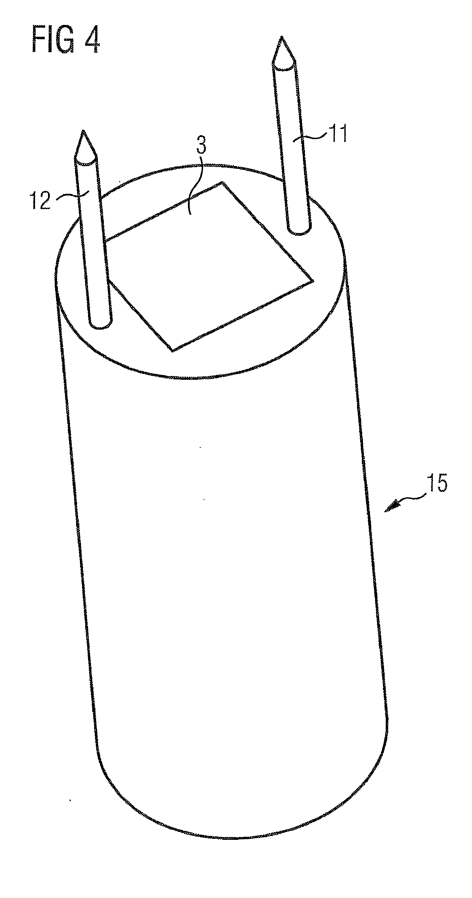

Nach der Bewicklung der Piezoeinheit mit dem Draht 14 und der Entfernung der überschüssigen Drahtabschnitte wird die Piezoeinheit dann mit einer Vergussmasse (z.B. Silikon) vergossen, so dass nach dem Aushärten der Vergussmasse ein fertiger Piezoaktor 15 entsteht, der in Figur 4 dargestellt ist.

Während des Vergießens fixiert die Montageaufnahme 1 die beiden Anschlussstifte 11, 12 in einer vorgegebenen Position, was für die spätere elektrische Kontaktierung des Piezoaktors 15 wichtig ist. Vorteilhaft daran ist die Tatsache, dass zur Fixierung der Anschlussstifte 11, 12 im Gegensatz zu den herkömmlichen Herstellungsverfahren keine separate Führung erforderlich ist.

Weiterhin ist zu erwähnen, dass die Aussparungen 9, 10 in der Montageaufnahme 1 größer sind als die Querschnittsfläche des Piezostapels 2, damit die Vergussmasse in den Zwischenraum eindringen kann.

Besonders vorteilhaft an der erfindungsgemäßen Montageaufnahme 1 ist ferner die Tatsache, dass die Stege 7, 8 zwischen den Stirnplatten 5, 6 der Montageaufnahme 1 die längs verlaufenden Kanten des Piezostapels 2 bei der Bewicklung mit dem Draht 14 schützen. Die Stege 7, 8 sind deshalb im Querschnitt winkelförmig und decken zwei gegenüberliegende Kanten des Piezostapels 2 ab. Hierbei verbleibt zwischen den Stegen 7, 8 und dem Piezostapel 2 ein Spalt, der groß genug ist, um ein Eindringen von Vergussmasse zu ermöglichen.

Die Erfindung ist nicht auf das vorstehend beschriebene bevorzugte Ausführungsbeispiel beschränkt, wie in den beigefügten Ansprüchen definiert.

## Patentansprüche

1. Piezoaktor (15), insbesondere zum Antrieb eines Injektors für eine Einspritzanlage einer Brennkraftmaschine, mit einer Halterung (5-10) zur Aufnahme und Halterung eines einzigen Piezostapels (2) und zweier zugehöriger Anschlussstifte (11, 12),
**dadurch gekennzeichnet,**
**dass** die Halterung (5-10) zur räumlichen Fixierung des Piezostapels (2) und der zwei zugehörigen Anschlussstifte (11, 12) während einer Herstellung einer elektrischen Kontaktierung des Piezostapels (2) mittels einer Bewicklung mit mindestens einem elektrisch leitfähigen Draht dient.

2. Piezoaktor (15) nach Anspruch 1,
**dadurch gekennzeichnet,**
**dass** die Halterung (5-10) einen Kantenschutz (7, 8) zum Schutz einer axial verlaufenden Kante des Piezostapels (2) aufweist.

3. Piezoaktor (15) nach Anspruch 2,
**dadurch gekennzeichnet,**
**dass** der Kantenschutz mindestens einen axial verlaufenden Steg (7, 8) aufweist, der eine axial verlaufende Kante des Piezostapels (2) abdeckt.

4. Piezoaktor (15) nach Anspruch 2 oder 3,
**dadurch gekennzeichnet,**
**dass** der Kantenschutz (7, 8) zwei axial verlaufende, einander gegenüber liegende Kanten des Piezostapels (2) abdeckt.

5. Piezoaktor (15) nach einem der vorhergehenden Ansprüche,
**dadurch gekennzeichnet,**
**dass** sich zwischen dem Kantenschutz (7, 8) und dem Piezostapel (2) ein Spalt befindet, der ausreichend groß ist, um beim Vergießen das Eindringen einer Vergussmasse zu ermöglichen.

6. Piezoaktor (15) nach einem der vorhergehenden Ansprüche,
**dadurch gekennzeichnet,**
**dass** die axial verlaufenden Kanten des Piezostapels (2) mit den Anschlussstiften (11, 12) und dem Kantenschutz (7, 8) im Querschnitt ein Polygon mit mindestens sechs Ecken bilden, um eine Drahtbewicklung zu erleichtern.

7. Piezoaktor (15) nach Anspruch 6,
**dadurch gekennzeichnet,**
**dass** das Polygon im wesentlichen gleichseitig ist, um eine Drahtbewicklung mit annähernd gleichbleibender Drahtspannung zu ermöglichen.

8. Piezoaktor (15) nach einem der vorhergehenden Ansprüche,
**dadurch gekennzeichnet,**
**dass** die Anschlussstifte (11, 12) in der Halterung formschlüssig und/ oder kraftschlüssig fixiert sind.

9. Piezoaktor (15) nach Anspruch 8,
**dadurch gekennzeichnet,**
**dass** die Anschlussstifte (11, 12) mit dem Material der Halterung (5-10) umspritzt oder umgossen sind.

10. Piezoaktor (15) nach einem der vorhergehenden Ansprüche,
**dadurch gekennzeichnet,**
**dass** die Halterung (5-10) im wesentlichen aus Kunststoff besteht.

11. Piezoaktor (15) nach einem der vorhergehenden Ansprüche,
**dadurch gekennzeichnet,**
**dass** die beiden Anschlussstifte (11, 12) in der Halterung (5-10) in jeweils zwei Querlagern fixiert sind.

12. Piezoaktor (15) nach einem der vorhergehenden Ansprüche,
**dadurch gekennzeichnet,**
**dass** die beiden Anschlussstifte (11, 12) in der Halterung (5-10) in jeweils einem Axiallager axial fixiert sind.

13. Piezoaktor (15) nach einem der vorhergehenden Ansprüche,
**dadurch gekennzeichnet,**
**dass** die Halterung (5-10) eine erste Stirnplatte (5) mit einer Aussparung (9) zur Führung des Piezostapels (2) an seinem einen Ende und eine zweite Stirnplatte (6) mit einer Aussparung (10) zur Führung des Piezostapels (2) an seinem anderen Ende aufweist, wobei die beiden Stirnplatten (5, 6) durch Stege (7, 8) miteinander verbunden sind.

14. Piezoaktor (15) nach Anspruch 13,
**dadurch gekennzeichnet,**
**dass** die Aussparung (9) in der ersten Stirnplatte (5) und/oder die Aussparung (10) in der zweiten Stirnplatte (6) größer ist als die Querschnittsfläche des Piezostapels (2), um das Eindringen von Vergussmasse zu ermöglichen.

15. Piezoaktor (15) nach einem der vorhergehenden Ansprüche,
**dadurch gekennzeichnet,**
**dass** die Halterung (5-10) mit dem eingesetzten Piezostapel (2) und den eingesetzten Anschlussstiften (11, 12) mit einer Vergussmasse vergossen ist.

16. Herstellungsverfahren für einen Piezoaktor (15) mit den folgenden Schritten:
- Einsetzen eines Piezostapels (2) und zweier Anschlussstifte (11, 12) in eine Montageaufnahme (1), wobei die Montageaufnahme (1) nur einen einzigen Piezostapel (2) und die zwei zugehörigen Anschlussstifte (11, 12) aufnimmt,
**gekennzeichnet durch** die Schritte:
- Bewicklung der Montageaufnahme (1) mit dem eingelegten Piezostapel (2) und den eingelegten Anschlussstiften (11, 12) mit mindestens einem elektrisch leitfähigen Draht (14) zur Herstellung einer elektrischen Verbindung zwischen den beiden Anschlussstiften (11, 12) und dem Piezostapel (2), während der Piezostapel (2) und die Anschlussstifte (11, 12) in die Montageaufnahme (1) eingesetzt sind.

17. Herstellungsverfahren nach Anspruch 16,
**gekennzeichnet durch**
folgenden Schritt:
- Vergießen der Montageaufnahme (1) mit dem eingesetzten Piezostapel (2) und den eingesetzten Anschlussstiften (11, 12) mit einer aushärtenden Vergussmasse.

18. Herstellungsverfahren nach Anspruch 17,
**gekennzeichnet durch**
folgende Schritte:
- Einsetzen der Montageaufnahme (1) mit dem eingelegten Piezostapel (2) und den eingelegten Anschlussstiften (11, 12) in eine Gussform und anschließend
- Vergießen der Montageaufnahme (1) mit der Vergussmasse in der Gussform.

19. Herstellungsverfahren nach einem der Ansprüche 16 bis 18, **gekennzeichnet durch**
folgende Schritte:
- Elektrische Verbindung von Drahtabschnitten des Drahts (14) mit jeweils einem der beiden Anschlussstifte (11, 12) und einem von zwei Anschlusskontakten (4) des Piezostapels (2),
- Trennung des Drahts (14) zwischen den kontaktierten Drahtabschnitten und Entfernung der abgetrennten Drahtabschnitte.

20. Herstellungsverfahren nach einem der Ansprüche 16 bis 19,
**dadurch gekennzeichnet,**
**dass** die Montageaufnahme (1) mindestens einen Kantenschutz (7, 8) aufweist, um eine axial verlaufende Kante des Piezostapels (2) zu schützen.

21. Herstellungsverfahren nach einem der Ansprüche 16 bis 20,
**dadurch gekennzeichnet,**
**dass** die Vergussmasse Silikon ist.

## Claims

1. Piezo actuator (15), in particular for driving an injector for an injection system of an internal combustion engine, having a mount (5-10) for receiving and securing a single piezo stack (2) and two associated connecting pins (11, 12),
**characterized**
**in that** the mount (5 - 10) serves to secure the piezo stack (2) and the two associated connecting pins (11, 12) spatially while electric contact is established with the piezo stack (2) by means of a winding with at least one electrically conductive wire.

2. Piezo actuator (15) according to Claim 1,
**characterized**
**in that** the mount (5 - 10) has an edge protection (7, 8) for protecting an axially extending edge of the piezo stack (2).

3. Piezo actuator (15) according to Claim 2,
**characterized**
**in that** the edge protection has at least one axially extending web (7, 8) which covers an axially extending edge of the piezo stack (2).

4. Piezo actuator (15) according to Claim 2 or 3,
**characterized**
**in that** the edge protection (7, 8) covers two axially extending edges of the piezo stack (2) which lie one opposite the other.

5. Piezo actuator (15) according to one of the preceding claims,
**characterized**
**in that** between the edge protection (7, 8) and the piezo stack (2) there is a gap which is sufficiently large to permit the ingress of a casting compound during casting.

6. Piezo actuator (15) according to one of the preceding claims,
**characterized**
**in that** the axially extending edges of the piezo stack (2) form in cross section, with the connecting pins (11, 12) and the edge protection (7, 8), a polygon with at least six corners, in order to facilitate a wire winding.

7. Piezo actuator (15) according to Claim 6,
**characterized**
**in that** the polygon is essentially equilateral, in order to permit a wire winding with approximately constant wire voltage.

8. Piezo actuator (15) according to one of the preceding claims,
**characterized**
**in that** the connecting pins (11, 12) are secured in the mount in a positively and/or non-positively locking fashion.

9. Piezo actuator (15) according to Claim 8,
**characterized**
**in that** the connecting pins (11, 12) are encapsulated with the material of the mount (5 - 10) by injection moulding or casting.

10. Piezo actuator (15) according to one of the preceding claims,
**characterized**
**in that** the holder (5 - 10) consists essentially of plastic.

11. Piezo actuator (15) according to one of the preceding claims,
**characterized**
**in that** the two connecting pins (11, 12) are secured in, in each case, two transverse bearings in the mount (5 - 10).

12. Piezo actuator (15) according to one of the preceding claims,
**characterized**
**in that** the two connecting pins (11, 12) are secured axially in the mount (5 - 10), in each case in an axial bearing.

13. Piezo actuator (15) according to one of the preceding claims,
**characterized**
**in that** the holder (5 - 10) has a first end plate (5) with a cutout (9) for guiding the piezo stack (2) at one of its ends, and a second end plate (6) with a cutout (10) for guiding the piezo stack (2) at its other end, wherein the two end plates (5, 6) are connected to one another by webs (7, 8).

14. Piezo actuator (15) according to Claim 13,
**characterized**
**in that** the cutout (9) in the first end plate (5) and/or the cutout (10) in the second end plate (6) is larger than the cross-sectional area of the piezo stack (2), in order to permit the ingress of casting compound.

15. Piezo actuator (15) according to one of the preceding claims,
**characterized**
**in that** the holder (5 - 10) is cast with a casting compound with the piezo stack (2) inserted and the connecting pins (11, 12) inserted.

16. Manufacturing method for a piezo actuator (15) having the following steps:
- insertion of a piezo stack (2) and second connecting pins (11, 12) into a mounting receptacle (1), wherein the mounting receptacle (1) accommodates only a single piezo stack (2) and the two associated connecting pins (11, 12),
**characterized by** the steps:
- winding of the mounting receptacle (1) with the piezo stack (2) inserted and the connecting pins (11, 12) inserted, with at least one electrically conductive wire (14) for establishing an electrical connection between the two connecting pins (11, 12) and the piezo stack (2) while the piezo stack (2) and the connecting pins (11, 12) are inserted into the mounting receptacle (1).

17. Manufacturing method according to Claim 16,
**characterized**
**by** the following step:
- casting the mounting receptacle (1) with a curing casting compound with the piezo stack (2) inserted and the connecting pins (11, 12) inserted.

18. Manufacturing method according to Claim 17,
**characterized**
**by** the following steps:
- insertion of the mounting receptacle (1) into a casting mould with the piezo stack (2) inserted and the connecting pins (11, 12) inserted, and subsequently
- casting of the mounting receptacle (1) in the casting mould with the casting compound.

19. Manufacturing method according to one of Claims 16 to 18,
**characterized**
**by** the following steps:
- electrical connection of wire sections of the wire (14) to, in each case, one of the two connecting pins (11, 12) and one of two connecting contacts (4) of the piezo stack (2),
- disconnection of the wire (14) between the wire sections with which contact has been made and removal of the cutoff wire sections.

20. Manufacturing method according to one of Claims 16 to 19,
**characterized**
**in that** the mounting receptacle (1) has at least one edge protection (7, 8) in order to protect an axially extending edge of the piezo stack (2).

21. Manufacturing method according to one of Claims 16 to 20,
**characterized**
**in that** the casting compound is silicone.

## Revendications

1. Piézo-actionneur (15), plus particulièrement pour l'entraînement d'un injecteur pour un dispositif d'injection d'un moteur à combustion interne, avec un support (5-10) pour le logement et le support d'une seule piézo-pile (2) et de deux tiges de connexion (11, 12) correspondantes,
**caractérisé en ce que**
le support (5-10) sert à fixer spatiallement la piézo-pile (2) et les deux tiges de connexion (11, 12) correspondante pendant l'établissement d'un contact électrique de la piézo-pile (2) à l'aide d'un enroulement avec au moins un fil électro-conducteur.

2. Piézo-actionneur (15) selon la revendication 1,
**caractérisé en ce que**
le support (5-10) comprend une protection d'arête (7, 8) pour la protection d'une arête axiale de la piézo-pile (2).

3. Piézo-actionneur (15) selon la revendication 2,
**caractérisé en ce que**
la protection d'arête comprend au moins une traverse axiale (7, 8) qui recouvre une arête axiale de la piézo-pile (2).

4. Piézo-actionneur (15) selon la revendication 2 ou 3,
**caractérisé en ce que**
la protection d'arête (7, 8) comprend au moins deux arêtes axiales opposées de la piézo-pile (2).

5. Piézo-actionneur (15) selon l'une des revendications précédentes,
**caractérisé en ce que**
entre la protection d'arête (7, 8) et la piézo-pile (2), se trouve un interstice qui est suffisamment grand pour permettre, lors du moulage, l'entrée d'une masse de coulée.

6. Piézo-actionneur (15) selon l'une des revendications précédentes,
**caractérisé en ce que**
les arêtes axiales de la piézo-pile (2) avec les tiges de connexion (11, 12) et la protection d'arête (7, 8) présentent une section transversale polygonale avec au moins six côtés afin de faciliter l'enroulement du fil.

7. Piézo-actionneur (15) selon la revendication 6,
**caractérisé en ce que**
le polygone présente des côtés globalement égaux afin de permettre un enroulement du fil avec une tension à peu près constante.

8. Piézo-actionneur (15) selon l'une des revendications précédentes,
**caractérisé en ce que**
les tiges de connexion (11, 12) sont fixées par complémentarité de forme et/ou par friction dans le support.

9. Piézo-actionneur (15) selon la revendication 8,
**caractérisé en ce que**
les tiges de connexion (11, 12) sont sur-injectées ou surmoulées avec le matériau du support (5-10).

10. Piézo-actionneur (15) selon l'une des revendications précédentes,
**caractérisé en ce que**
le support (5-10) est constitué essentiellement d'une matière plastique.

11. Piézo-actionneur (15) selon l'une des revendications précédentes,
**caractérisé en ce que**
les deux tiges de connexion (11, 12) sont fixées dans le support (5-10) chacun dans un palier transversal.

12. Piézo-actionneur (15) selon l'une des revendications précédentes,
**caractérisé en ce que**
les deux tiges de connexion (11, 12) sont fixées axialement dans le support (5-10) chacun dans un palier axial.

13. Piézo-actionneur (15) selon l'une des revendications précédentes,
**caractérisé en ce que**
le support (5-10) comprend une première plaque frontale (5) avec un évidement (9) pour le guidage de la piézo-pile (2) au niveau de son extrémité et une deuxième plaque frontale (6) avec un évidement (10) pour le guidage de la piézo-pile (2) au niveau de son autre extrémité, les deux plaques frontales (5, 6) étant reliées entre elles par des traverses (7, 8).

14. Piézo-actionneur (15) selon la revendication 13,
**caractérisé en ce que**
l'évidement (9) dans la première plaque frontale (5) et/ou l'évidement (10) dans la deuxième plaque frontale (6) est plus grand que la surface de la section transversale de la piézo-pile (2) afin de permettre l'entrée d'une masse de coulée.

15. Piézo-actionneur (15) selon l'une des revendications précédentes,
**caractérisé en ce que**
le support (5-10) est moulé avec la piézo-pile (2) enchâssée et les tiges de connexion (11, 12) enchâssées, avec une masse de coulée.

16. Procédé de fabrication pour un piézo-actionneur (15), comprenant les étapes suivantes :
- insertion d'une piézo-pile (2) et de deux tiges de connexion (11, 12) dans un logement de montage (1), le logement de montage (1) logeant une seule piézo-pile (2) et les deux tiges de connexion (11, 12) correspondantes,
**caractérisé par** les étapes suivantes :
- enroulement du logement de montage (1) avec la piézo-pile (2) insérée et les tiges de connexion (11, 12) insérées, avec au moins un fil électro-conducteur (14), pour l'établissement d'une liaison électrique entre les deux tiges de connexion (11, 12) et la piézo-pile (2), tandis que la piézo-pile (2) et les tiges de connexion (11, 12) sont insérées dans le logement de montage (1).

17. Procédé de fabrication selon la revendication 16, **caractérisé par** l'étape suivante :
- moulage du logement de montage (1) avec la piézo-pile (2) insérée et les tiges de connexion (11, 12) insérées avec une masse de coulée durcissable.

18. Procédé de fabrication selon la revendication 17, **caractérisé par** les étapes suivantes :
- insertion du logement de montage (1) avec la piézo-pile (2) insérée et les tiges de connexion (11, 12) insérées dans un moule puis
- moulage du logement de montage (1) avec la masse de coulée dans le moule.

19. Procédé de fabrication selon l'une des revendications 16 à 18,
**caractérisé par** les étapes suivantes :
- liaison électrique de portions du fil (14) chacune avec une des deux tiges de connexion (11, 12) et un des deux contacts de connexion (4) de la piézo-pile (2),
- séparation du fil (14) entre les portions de fil en contact et élimination des portions de fils coupées.

20. Procédé de fabrication selon l'une des revendications 16 à 19,
**caractérisé en ce que**
le logement de montage (1) comprend au moins une protection d'arête (7, 8) afin de protéger une arête axiale de la piézo-pile (2).

21. Procédé de fabrication selon l'une des revendications 16 à 20,
**caractérisé en ce que** la masse de coulée est du silicone.
